# EUROPEAN PATENT SPECIFICATION

(11) **EP 0 285 168 B1**
(45) Date of publication and mention of the grant of the patent: **22.02.1995**
(21) Application number: 88105293.0
(22) Date of filing: 31.03.1988
(51) Int. Cl.: H01L 39/24

(54) **Superconducting wire and method of manufacturing the same**
Supraleitender Draht und Verfahren zu seiner Herstellung
Fil supra-conducteur et procédé pour sa fabrication

(30) Priority: 02.04.1987 JP 81820/87; 07.04.1987 JP 86563/87; 13.04.1987 JP 90147/87
(43) Date of publication of application: 05.10.1988
(73) Proprietor: SUMITOMO ELECTRIC INDUSTRIES LIMITED, Osaka-shi, Osaka 541 (JP)
(72) Inventor: Masanobu, Nishio c/o Osaka Works, Konohana-ku Osaka-shi Osaka (JP); Kazuhiko, Hayashi c/o Osaka Works, Konohana-ku Osaka-shi Osaka (JP); Yoshihiro, Nakai c/o Osaka Works, Konohana-ku Osaka-shi Osaka (JP); Kengo, Ohkura c/o Osaka Works, Konohana-ku Osaka-shi Osaka (JP); Kazuo, Sawada c/o Osaka Works, Konohana-ku Osaka-shi Osaka (JP)
(74) Representative: KUHNEN, WACKER & PARTNER

(56) References cited:
- FR-A- 2 410 368
- US-A- 3 868 241
- US-A- 4 103 063
- US-A- 4 104 355
- PHYSICAL REVIEW LETTERS, vol. 58, no. 9, 2 March 1987, pages 908-910, New York, US; M. K. WU et al.: "Superconductivity at 93 K in a New Mixed-Phase Y-Ba-Cu-O Compound System at Ambient Pressure"
- ADVANCED CERAMIC MATERIALS, vol. 2, no. 3b, Special issue July 1987, pages 539-555, Columbus, Ohio, US; E.C. BEHRMAN et al.: "Synthesis Characterization, and Fabrication of High Temperature Superconducting Oxides"

## Description

### BACKGROUND OF THE INVENTION

### Field of the Invention

The present invention relates to a method of manufacturing a superconducting wire, and more particularly, it relates to a method of manufacturing a superconducting wire of a ceramics superconductive material.

### Description of the Prior Art

Metal and ceramics superconductors have generally been well known in the art, and study has been made for application of such superconductors to various uses. A superconductor loses all resistance to electric current when the same is held at a temperature below its critical temperature. Through such a property, attempts have been made for generation of a high magnetic field and high density transmission of current of large capacity.

In order to apply a superconductor to generation of a high magnetic field or high density transmission, it is necessary to provide the same in the form of a considerably thin wire rod. Also in application other than the above, such a superconductor must be worked into a fine wire rod in a considerable probability.

Within various types of general superconductors, applicable to the aforementioned uses are only those which can be worked into wire rods with no degradation in property. However, although metal superconductive materials can be easily worked into wire rods cf. FR-A-2 410 368, critical temperatures thereof, e.g., being lower than about 23 K, are considerably low to largely restrict employable cooling mediums, whereby application thereof is extremely limited.

On the other hand, some of ceramics superconductive materials have considerably high critical temperatures. However, it is extremely difficult to work such ceramics superconductive materials into wire rods. Even if the materials are worked into wire rods, it is extremely difficult to provide stable electrical properties over the entire length thereof.

In general, a wire rod of a ceramics superconductor is manufactured by:
(1) a method of performing cold working at the normal temperature; or
(2) a method of heating the material to a temperature for facilitating plastic working.

In the case of the method (1), however, material powder is localized with wire drawing of the raw material for a ceramics superconductor to cause disconnection, and hence the degree of fineness of the wire rod is restricted. Further, even if the superconductor is worked into a wire rod of considerable thickness, electrical properties thereof are degraded to some extent.

In the case of the method (2), a raw material for the ceramics superconductor is generally filled in a metal pipe to be heated to a high temperature and thereafter extruded into the form of a wire rod, to be further subjected to wire drawing by a die or the like, if necessary. Thus, the raw material for the ceramics superconductor is subjected to heat treatment in a state isolated from the external atmosphere by the metal pipe, with insufficient reaction to elements required for the superconductor, such as oxygen. Thus, the superconductor cannot be provided with expected critical temperature and critical current. Further, the degree of fineness of the wire rod is restricted.

Ceramics superconductive materials are recently being watched as the same can be increased in critical temperature of superconduction. Such superconductive materials can be shaped into elongated linear bodies, for example, to be applied to uses such as power transmission/distribution, electric connection of various devices or elements, winding for a coil, and the like.

It has been proved that, within such ceramics superconductive materials, those of Y-Ba-Cu-O, for example, being in perovskite or pseudo-perovskite structure superconducts at high critical temperatures.

### SUMMARY OF THE INVENTION

An object of the present invention is to provide a method of efficiently manufacturing a superconducting wire of a ceramics superconductive material composed in design according to claim 1, which can be increased in critical temperature and worked into a wire rod with no degradation in electrical property.

The present invention provides a method of manufacturing a superconductor made of a ceramics superconductive material, preferably a compound material containing oxygen and at least two sorts of metal elements and being in layer structure.

Provided according to the present invention is a method of manufacturing a ceramics superconductor which is in composition generally expressed in a formula AaBbCc. In this general formula, A represents at least a single sort of element, preferably at least two sorts of elements selected from a group of those belonging to the groups Ia, IIa and IIIa of the periodic table. The elements belonging to the group Ia of the periodic table are H, Li, Na, K, Rb, Cs and Fr. The elements belonging to the group IIa of the periodic table are Be, Mg, Ca, Sr, Ba and Ra. The elements belonging to the group IIIa of the periodic table are Sc, Y, La, Ce, Pr, Nd, Pm, Sm, Eu, Gd, Tb, Dy, Ho, Er, Tm, Yb, Ly, Ac, Th, Pa, U, Np, Pu, Am, Cm, Bk, Cf, Es, Fm, Md, No and Lr.

On the other hand, B in the general formula represents at least a single sort of element selected from a group of those belonging to the groups Ib, IIb and IIIb of the periodic table. The elements belonging to the group Ib of the periodic table are Cu, Ag and Au and those belonging to the group IIb are Zn, Cd and Hg, while those belonging to the group IIIb are B, Al, Ga, In and Tl.

C represents at least a single sort of element selected from a group of oxygen, carbon, nitrogen, fluorine and sulfur.

The general a, b and c represent numbers showing the composition ratio of A, B and C respectively. Relation a x (average valence of A) + b x (average valence of B) = c x (average valence of C) generally holds for a, b and c, while satisfaction of such relation is not necessarily required.

In the above final composition, B preferably contains at least copper and C preferably contains at least oxygen, for the possibility of attaining a higher critical temperature.

According to the inventive method of manufacturing a superconducting wire, first prepared is a raw material composed of a compound containing oxygen and at least two sorts of metal elements and being in layer structure, or a raw material being in composition generally expressed in the formula AaBbCc. The raw material is molten in a vessel having a hole provided to communicate with its interior. A melt obtained by such melting is linearly discharged from the hole by either extrusion or drawout. The linearly discharged melt is cooled and solidified. This melt may be solidified by forced cooling or natural standing. Further, at least a sort of vitrifying compound such as B₂O₃, GeO₂ or P₂O₅ may be added in the step of melting the raw material, in order to bring the melt into a highly viscous glassy state. In this case, the solidified body as obtained may be crystallized by further re-heating.

According to the aforementioned method of manufacturing a superconducting wire rod, the ceramics superconductive material can be brought into a considerably viscous state through melting in a heating vessel. Thus, a superconducting wire rod can be obtained by extruding or drawing out the melt from the hole. Since the melt is extruded or drawn out in the considerably viscous state, the wire rod can be extremely reduced in thickness along the size of the hole.

Thus, according to the present invention, a superconducting wire rod is manufactured by melting a ceramics superconductive material and extruding or drawing out the same, whereby a superconducting wire rod having a high critical temperature and excellent electrical properties can be obtained by a simple method.

In the aforementioned melting - cooling/solidifying method according to the present invention, it is difficult to obtain a ceramics superconducting wire being composed in design even if the raw material is correctly prepared in composition. The composition of the ceramics superconducting wire is easily fluctuated by dissociation or coupling of elements contained in the raw material being in a molten state. In consideration of this, the inventors have found out that a ceramics superconducting wire can be reliably composed in design by adjusting an atmosphere at least in one of the entire steps including melting and cooling/solidifying steps.

According to the inventive method of manufacturing a superconducting wire based on the aforementioned point of view, prepared is a raw material being in composition generally expressed in a formula AaBbC^{x}c^{x} in manufacturing of a ceramics superconductor of the aforementioned composition. In the general formula AaBbC^{x}c^{x}, C^{x} represents at least a single sort of element selected from a group of oxygen, carbon, nitrogen and sulfur, which may be identical to the aforementioned element C or a part of C if C consists of two or more elements. The general c^{x} represents a number showing the composition ratio of C^{x}.

According to this manufacturing method, the material expressed as AaBbC^{x}c^{x} is first prepared to be molten. The method further comprises at least a step of linearly discharging a melt of AaBbC^{x}c^{x} obtained by melting through extrusion or drawout and a step of cooling and solidifying the linearly discharged melt of AaBbC^{x}c^{x}.

This manufacturing method may comprise at least the melting step, the discharging step and the cooling/solidifying step, and hence some steps may be freely performed after the melt is solidified.

Further, the inventive manufacturing method is characterized in that at least one of the entire steps including the aforementioned melting, discharging and cooling/solidifying steps is performed under an atmosphere containing a C^{y} component of partial pressure being higher than C^{y} partial pressure in the atmospheric air. The C^{y} component is prepared by a gas containing at least a single sort of element selected from a group of oxygen, nitrogen, carbon, fluorine and sulfur. C^{y} may be identical to C in the aforementioned final composition expressed in the general formula AaBbCc, while the same at least contains difference between C and C^{x}, i.e., an element left by eliminating C^{x} from C if C consists of two or more elements. Examples of the C^{y} gas are oxygen, nitrogen, carbon monoxide, carbon dioxide, hydrogen fluoride and hydrogen sulfide.

The aforementioned atmosphere in which C^{y} partial pressure is higher than that in the atmospheric air may be introduced into "at least" one of the entire steps. Thus, only the melting step may be performed under the said atmosphere, while only the cooling/solidifying step may alternatively be performed under the said atmosphere. The melting step or the cooling/solidifying step is so performed under this atmosphere that melting or cooling/solidification is carried out in an atmosphere being rich in C^{y}. Therefore, if C^{x} is smaller in sort or amount of elements than C in the final composition, C^{y} can be added to the material being in a molten or cooled state from the C^{y} atmosphere, thereby to reliably attain Cc in the final composition.

If C^{x} contained in the material is identical to C in the final composition, on the other hand, C^{y} is prepared to be identical in element to C^{x} and C thereby to suppress dissociation of the C component in the material being in a molten state or a state directed to solidification, or recombine the same upon dissociation.

The material may be re-heated after the cooling/solidifying step under an atmosphere in which C^{y} partial pressure is higher than that in the atmospheric air. In this case, C in the final composition can be attained by supplying the C^{y} component in the re-heating step.

It is pointed out that the material expressed in the aforementioned general formula AaBbC^{x}c^{x} can be prepared by a partially fabricated item which is not completely superconductive, in addition to a mixed body and a compact.

Thus, according to the present invention, an element which is easily dissociated or changed in a molten state can be prevented from such dissociation or change by adjusting an atmosphere introduced into a part of the manufacturing steps, while an element not contained in the raw material can be supplied from the aforementioned atmosphere as the case may be. Thus, a ceramics superconducting wire can be reliably composed in design.

It is pointed out that the inventive manufacturing method is applicable to a method of manufacturing a ceramics superconducting wire which is employed for general application of such a superconducting wire, in addition to that employed in the field of energy such as a high current density magnet or a long-distance transmission line or an electronic device such as a Josephson device.

The present invention is further directed to a method of manufacturing a superconducting wire comprising the steps of melting a ceramics superconductive material in a vessel heated to a temperature exceeding the melting point thereof and extruding or drawing out the molten superconductive material from a hole communicating with the interior of the vessel to cool/solidify the same. This method is characterized in that the cooling/solidifying step is performed in a space being at a temperature between the solidifying point of the superconductive material and a temperature lower by 100°C than the solidifying point.

According to the present invention, a ceramics superconductive material being molten in a vessel is discharged from a hole communicating with the interior of the vessel to be cooled/solidified. The cooling/solidifying step is performed in an atmosphere of a temperature close to the solidifying point of the superconductive material, i.e., at a temperature level between the solidifying point and that lower by 100°C than the solidifying point, thereby to reduce thermal distortion caused in solidification of the molten superconductive material. Therefore, an elongated superconducting wire can be manufactured in high productivity with no breaking in or upon solidification of the molten ceramics superconductive material. If the temperature of the space for performing the cooling/solidifying step is less than the temperature lower by 100°C than the solidifying point, an elongated superconducting wire cannot be readily obtained and the solidified superconducting wire is easily broken. It has been also confirmed by reduction in critical temperature that, if the said temperature is less than that lower by 100°C than the solidifying point as described above, the cooled/solidified ceramics material is not brought into desired perovskite or pseudo-perovskite structure, or the ratio of such crystal structure is reduced. The temperature of the space for carrying out the cooling/solidifying step is preferably selected to be closer to the solidifying point of the superconductive material, i.e., at a temperature level between the solidifying point and that lower by 50°C than the solidifying point in order to further reduce thermal distortion caused in solidification, thereby to further effectively manufacture an elongated superconducting wire of a ceramics superconductive material being in desired perovskite or pseudo-perovskite structure.

Preferably a zone next to the space for performing the cooling/solidifying step is provided to be at a relatively high temperature in a portion closer to the hole of the vessel while having a temperature gradient along a direction for linearly discharging the melt, so that the cooled/solidified superconducting wire is passed through the zone to be slowly cooled. Desired perovskite or pseudo-peroskite structure can be further excellently attained in a superconducting wire thus obtained. This has been confirmed by measurement of a critical temperature. Particularly in slow cooling of the superconducting wire, an average cooling rate is preferably selected to be not more than 10°C/min. at least until the temperature reaches 200°C.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic process diagram showing a method of manufacturing a superconducting wire according to the present invention sequentially along steps;
Fig. 2 is a schematic block diagram showing an embodiment of an apparatus for manufacturing a superconducting wire rod based on the inventive manufacturing method; and
Fig. 3 is a schematic block diagram showing another embodiment of the inventive manufacturing method.

### DESCRIPTION OF THE PREFERRED EMBODIMENTS

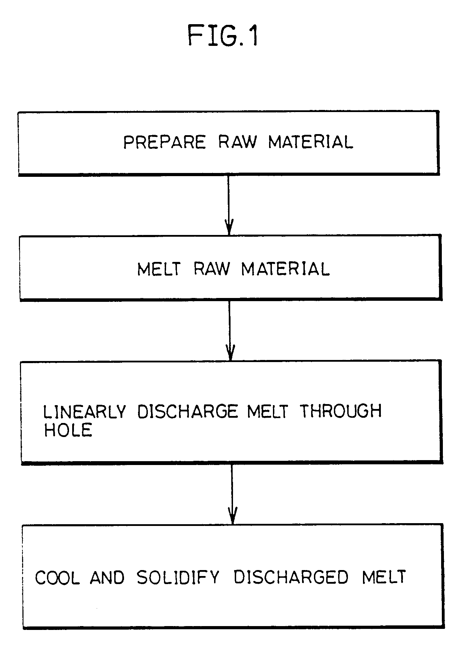

Fig. 1 is a process diagram schematically showing a method of manufacturing a superconducting wire according to the present invention. Referring to Fig. 1, a raw material of prescribed composition is first prepared in the form of powder, a compact or the like. This raw material is molten in a vessel having a hole provided to communicate with its interior. A melt thus obtained is linearly discharged from the hole through extrusion or drawout. The linearly discharged melt is thereafter cooled to be solidified. Thus, a superconducting wire of prescribed composition is obtained in the form of a solidified body.

The inventive method of manufacturing a superconducting wire is now described with reference to Examples.

### Example 1

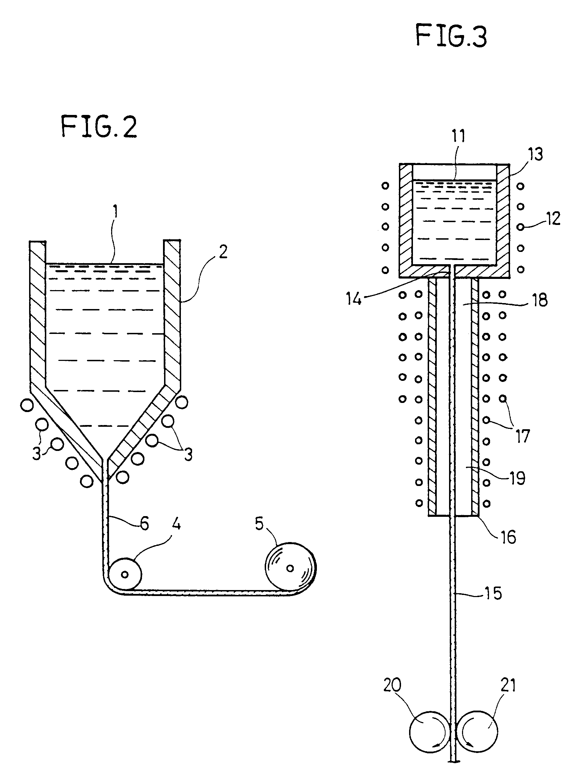

Fig. 2 is a schematic block diagram showing an embodiment of a superconducting wire rod manufacturing apparatus for carrying out the present invention. A heating source 3 is provided in proximity to an extrusion port of a heating furnace 2 containing powder of a ceramics superconductive material 1. Further provided are a guide roll 4 for guiding a ceramics superconducting wire extruded through the extrusion port and a take-up roll 5 for winding the ceramics superconducting wire.

In more concrete terms, powder of Y₂O₃, BaCO₃ and CuO mixed in the ratio 0.2:0.6:1 was preliminarily sintered at 900°C for 10 hours and pulverized to prepare the ceramics superconductive material 1, which could be brought into a half-molten state by raising up the inner temperature of the heating furnace 2 to 1000°C by the heating source 3.

The ceramics superconductive material 1 was extruded from the extrusion port to be wound on the take-up roll 5 through the guide roll 4, thereby to obtain a fine wire 6 of 100 »m in diameter.

Sharp superconductivity transition was observed in the superconducting fine wire 6 thus obtained, with a critical temperature of 90 K and critical current of 20 A.

Thus, a superconducting magnet having a high critical temperature and excellent electrical properties can be implemented through the superconducting fine wire obtained in the aforementioned manner. Alternatively, a superconducting transmission cable having a high critical temperature and excellent electrical properties can be implemented through the superconducting fine wire.

In order to form such a superconducting magnet or superconducting transmission cable, a stabilizing material such as copper is preferably adapted to hold or be held by a large number of fine wires, to prevent heat generation in quenching for transition into normal conduction as well as to prevent burning of the superconducting fine wires.

The present invention is not restricted to the aforementioned Example but a ceramics superconducting material can be molten in a coarsely crushed state or the diameter of the wire rod can be set in a desired value other than 100 »m. Further, various modifications may be introduced in design within a scope of the present invention.

### Example 2

A mixture of Y₂O₃, BaCO₃ and CuO was molded and previously subjected to heat treatment, to be heated/molten in a crucible under an atmosphere containing oxygen of 2,67·10⁴ Pa (200 Torr). Then the melt was drawn out from a nozzle of 500 »m in bore diameter, to be solidified in the form of a fine wire. The fine wire thus obtained was made of a ceramics superconductive material composed of Y_{0.4}Ba_{0.6}CuO_{2.2}, which superconducted at 90 K.

### Example 3

A material being in average composition of La_{1.6}Sr_{0.34}CuO₄ containing 0.01 wt.% of fluorine was molten in a crucible under an atmosphere containing SF₆ gas of 1,33·10⁴ Pa (100 Torr)., to manufacture a tape-like member of 30 »m in thickness and 60 mm in width similarly under an atmosphere containing SF₆ gas of 1.33·10⁴ Pa (100 Torr) by the so-called roll quenching method. This tape-like member superconducted at 40 K.

### Example 4

The material obtained in Example 2 was heated under an atmosphere containing oxygen of 2.67·10⁴ Pa (200 torr) at 1100°C for two hours, to obtain a ceramics superconductive material of Y_{0.4}Ba_{0.6}CuO_{2.5}. This ceramics superconductive material superconducted at a temperature of 95 K.

### Example 5

Fig. 3 illustrates a state of carrying out Example 5.

A ceramics superconductive material 11 of YBa₂Cu₃O₇ having a solidifying point of about 1090°C was molten at a temperature of 1180°C in a platinum crucible 13 heated by a heater 12. The molten ceramics superconductive material 11 was drawn out from a hole 14 provided on the bottom wall of the crucible 13 to be cooled/solidified, thereby to obtain a superconducting wire 15.

The space for performing the aforementioned cooling/solidifying step was enclosed by a tunnel 16, for example, and provided with a prescribed temperature atmosphere by a heater 17 arranged in relation to the tunnel 16. Namely, the tunnel 16 was provided in its relatively upward portion with a cooling/solidifying space 18 being brought into a higher temperature atmosphere, while a slow-cooling zone 19 was formed in communication with the cooling/solidifying space 18. The cooling/solidifying space 18 was set at a temperature of 1080°C, while a lower end of the slow-cooling zone 19 was set at a temperature of 1050°C.

The superconducting wire 15 discharged from the tunnel 16 was drawn out through a pair of rollers 20 and 21 rotated along arrows in Fig. 3.

The superconducting wire 15 thus obtained was 50 »m in diameter, and superconducted at a critical temperature of 85 K.

Reference example was prepared by the same superconducting wire 15 to draw out the same while stopping heating by the heater 17. However, the superconducting wire 15 was occasionally broken.

A superconducting wire obtained by the inventive method is not restricted to that of a circular section. The sectional configuration of the superconducting wire depends on that of the hole 14 provided to communicate with the interior of the crucible 13, and a superconducting wire of an arbitrary sectional configuration, such as a tape-like one, can be obtained by changing the configuration of the hole 14.

### Example 6

Respective powder materials of Bi₂O₃, SrCO₃, CaCO₃ and CuO were weighed so that Bi, Sr, Ca and Cu were in the composition ratio 1:1:1:2 and mixed with each other to be temporarily fired in the atmospheric air at 800°C for eight hours, thereby to prepare raw material powder to be molten.

This powder was introduced into a crucible to be molten, drawn out and solidified in the atmospheric air through the apparatus as shown in Fig. 3, thereby to obtain a fine wire of 100 »m in diameter. This fine wire was annealed in the atmospheric air at 830°C for eight hours, and thereafter slowly cooled. The critical temperature T_{C} of the fine wire thus obtained was measured through measurement of electric resistance by a general four-terminal method. This fine wire was in such superconductivity that its electric resistance reached zero at 100 K.

### Example 7

A material obtained by adding B₂O₃ of 20 % in mole ratio to a ceramics superconductive material composed of Y₁Ba₂Cu₃O₇₋ₓ was introduced into a crucible to be molten, drawn out and solidified in the atmospheric air at 800°C through the apparatus as shown in Fig. 3, thereby to obtain a fine wire of 50 »m in diameter This fine wire was in a partially crystallized glassy state. Then the fine wire was annealed in the atmospheric air at 700°C for six hours, and thereafter slowly cooled. The critical temperature T_{C} of this fine wire was 85 K.

## Claims

1. A method of manufacturing a superconducting wire composed of ceramics superconductive material of a composition expressed by a general formula AaBbCc, wherein:
i) A represents single set of elements selected from a group, said group consisting of: Bi, Sr and Ca or Y and Ba or, La and Sr;
ii) B represents Cu (copper);
iii) C represents at least a single sort of element selected from a group consisting of: Oxygen; sulfur and fluorine; and
iv) a, b, c represent numbers showing the composition ratio of A, B and C, respectively;
and said method comprising:
a step of preparing a raw material for said ceramics superconductive material;
a step of melting said raw material in a vessel having a hole;
a step of linearly discharging said melt from said hole by either extrusion or drawout; and
a step of cooling and solidifying said linearly discharged melt to obtain a solidified body.

2. A method of manufacturing a superconducting wire in accordance with claim 1, wherein
said step of melting said raw material to obtain a melt includes a step of adding at least a single sort of vitrifying compound selected from a group of B₂O₃, GeO₂ and P₂O₅ to said material in said vessel so as to obtain a melt in a viscous glassy state.

3. A method of manufacturing a superconducting wire in accordance with claim 2, further comprising a step of re-heating said solidified body to crystallize the same.

4. A method of manufacturing a superconducting wire in accordance with claim 1, wherein
said raw material is in composition generally expressed in a formula AaBbC^{x}c^{x}, where C^{x} represents at least a single sort of element selected from a group consisting of: Oxygen, sulfur and fluorine and c^{x} represents a number showing the composition ratio of C^{x}; and
at least one of said melting step, said step of discharging said melt and said cooling and solidifying step is performed in an atmosphere containing a C^{y} component of partial pressure being higher than C^{y} partial pressure in the atmospheric air, C^{y} being prepared by a gas containing at least a single sort of element selected from a group consisting of: Oxygen, nitrogen, carbon, fluorine and sulfur and at least containing an element left by eliminating said C^{x} from said C if said C consists of two or more sorts of elements.

5. A method of manufacturing a superconducting wire in accordance with claim 4, wherein
said C^{x} and said C^{y} are identical to said C.

6. A method of manufacturing a superconducting wire in accordance with claim 4 or 5, wherein
said melting step comprises a step of adding said C^{y} to said melt in an atmosphere containing said C^{y} component of partial pressure being higher than C^{y} partial pressure in the atmospheric air.

7. A method of manufacturing a superconducting wire in accordance with at least one of the claims 4 through 6, wherein
said cooling and solidifying step comprises a step of cooling and solidifying said melt in an atmosphere containing said C^{y} component of partial pressure being higher than C^{y} partial pressure in the atmospheric air.

8. A method of manufacturing a superconducting wire in accordance with at least one of the claims 4 through 7, further comprising a step of re-heating said solidified body in an atmosphere containing said C^{y} component of partial pressure being higher than C^{y} partial pressure in the atmospheric air after said cooling and solidifying step.

9. A method of manufacturing a superconducting wire in accordance with claim 1, wherein
said raw material is in composition expressed in said general formula AaBbCc; and
said cooling and solidifying step is performed in a space of a temperature level between the solidifying point of said raw material and that lower by 100°C than said solidifying point.

10. A method of manufacturing a superconducting wire in accordance with claim 9, wherein
said cooling and solidifying step comprises a step of cooling and solidifying said melt in a space of a temperature level between said solidifying point and that lower by 50°C than said solidifying point.

11. A method of manufacturing a superconducting wire in accordance with claim 9 or 10, wherein
a zone next to said space for performing said cooling and solidifying step is provided to be at a relatively high temperature in a portion closer to said hole while having a temperature gradient along a direction for linearly discharging said melt,
said method further comprising a step of passing said solidified body through said zone thereby to slowly cool the same.

## Patentansprüche

1. Verfahren zur Herstellung eines supraleitenden Drahtes, welcher aus einem keramischen supraleitenden Material einer Zusammensetzung, die durch die allgemeine Formel AaBbCc ausgedrückt wird, zusammengesetzt ist, worin:
i) A einen einzelnen Satz von Elementen, ausgewählt aus einer Gruppe, wobei die Gruppe aus Bi, Sr und Ca, oder Y und Ba oder La und Sr besteht, darstellt;
ii) B Cu (Kupfer) darstellt;
iii) C wenigstens eine einzelne Art von Element, ausgewählt aus einer Gruppe, bestehend aus Sauerstoff, Schwefel und Fluor, darstellt; und
iv) a, b, c Zahlen darstellen, welche das Zusammensetzungsverhältnis von A, B bzw. C zeigen;
und das Verfahren umfaßt:
einen Schritt des Vorbereitens eines Rohmaterials für das keramische supraleitende Material;
einen Schritt des Schmelzens des Rohmaterials in einem Gefäß, welches ein Loch aufweist;
einen Schritt des linearen Ablassens der Schmelze aus dem Loch, durch entweder Extrusion oder Herausziehen; und
einen Schritt des Abkühlens und Verfestigens der linear abgelassenen Schmelze, um einen verfestigten Körper zu erhalten.

2. Verfahren zur Herstellung eines supraleitenden Drahtes gemäß Anspruch 1, worin
der Schritt des Schmelzens des Rohmaterials um eine Schmelze zu erhalten, einen Schritt des Zugebens von wenigstens einer einzelnen Art einer vitrifizierenden Verbindung, ausgewählt aus einer Gruppe von B₂O₃, GeO₂ und P₂O₅ zu dem Material in dem Gefäß einschließt, um so eine Schmelze in einem viskosen glasartigen Zustand zu erhalten.

3. Verfahren zur Herstellung eines supraleitenden Drahtes gemäß Anspruch 2, welches weiterhin einen Schritt des Wiedererwärmens des verfestigten Körpers umfaßt, um denselben zu kristallisieren.

4. Verfahren zur Herstellung eines supraleitenden Drahtes gemäß Anspruch 1, worin
das Rohmaterial in einer Zusammensetzung ist, welche allgemein in einer Formel AaBbC^{x}c^{x} ausgedrückt ist, wo C^{x} wenigstens eine einzelne Art von Element, ausgewählt aus einer Gruppe bestehend aus Sauerstoff, Schwefel und Fluor darstellt, und c^{x} eine Zahl darstellt, welche das Zusammensetzungsverhältnis von C^{x} zeigt; und
wenigstens einer von dem Schmelzschritt, dem Schritt des Ablassens der Schmelze und dem Abkühlungs- und Verfestigungsschritt in einer Atmosphäre durchgeführt wird, welche einen C^{y}-Bestandteil mit einem Partialdruck enthält, welcher höher ist als der C^{y}-Partialdruck in der Luftatmosphäre, wobei C^{y} aus einem Gas hergestellt wird, welches wenigstens eine einzelne Art von Element, ausgewählt aus einer Gruppe bestehend aus Sauerstoff, Stickstoff, Kohlenstoff, Fluor und Schwefel enthält, und wenigstens ein Element enthält, welches durch Eliminieren des C^{x} aus dem C zurückbleibt, wenn das C aus zwei oder mehr Arten von Elementen besteht.

5. Verfahren zur Herstellung eines supraleitenden Drahtes gemäß Anspruch 4, worin
das C^{x} und das C^{y} identisch mit dem C sind.

6. Verfahren zur Herstellung eines supraleitenden Drahtes gemäß Anspruch 4 oder 5, worin
der Schmelzschritt einen Schritt des Zugebens des C^{y} zu der Schmelze in einer Atmosphäre umfaßt, welche den C^{y}-Bestandteil mit einem Partialdruck enthält, der höher ist als der C^{y}-Partialdruck in der Luftatmosphäre.

7. Verfahren zur Herstellung eines supraleitenden Drahtes gemäß wenigstens einem der Ansprüche 4 bis 6, worin
der Abkühlungs- und Verfestigungsschritt einen Schritt des Abkühlens und Verfestigens der Schmelze in einer Atmosphäre umfaßt, welche den C^{y}-Bestandteil mit einem Partialdruck enthält, der höher ist als der C^{y}-Partialdruck in der Luftatmosphäre.

8. Verfahren zur Herstellung eines supraleitenden Drahtes gemäß wenigstens einem der Ansprüche 4 bis 7, welches weiterhin nach dem Abkühlungs- und Verfestigungsschritt einen Schritt des Wiedererwärmens des verfestigten Körpers in einer Atmosphäre umfaßt, welche den C^{y}-Bestandteil mit einem Partialdruck enthält, der höher ist als der C^{y}-Partialdruck in der Luftatmosphäre.

9. Verfahren zur Herstellung eines supraleitenden Drahtes gemäß Anspruch 1, worin
das Rohmaterial in einer Zusammensetzung vorliegt, welche in der allgemeinen Formel AaBbCc ausgedrückt ist; und
der Abkühlungs- und Verfestigungsschritt in einem Raum mit einem Temperaturniveau zwischen dem Verfestigungspunkt des Rohmaterials und dem, welcher 100°C niedriger als der Verfestigungspunkt ist, durchgeführt wird.

10. Verfahren zur Herstellung eines supraleitenden Drahtes gemäß Anspruch 9, worin
der Abkühlungs- und Verfestigungsschritt einen Schritt des Abkühlens und Verfestigens der Schmelze in einem Raum mit einem Temperaturniveau zwischen dem Verfestigungspunkt und dem, welcher 50°C niedriger als der Verfestigungspunkt ist, umfaßt.

11. Verfahren zur Herstellung eines supraleitenden Drahtes gemäß Anspruch 9 oder 10, worin
eine Zone neben dem Raum zum Durchführen des Abkühlungs- und Verfestigungsschrittes zur Verfügung gestellt wird, welche in einem Bereich näher zu dem Loch eine relativ hohe Temperatur aufweist, während sie einem Temperaturgradienten entlang einer Richtung zum linearen Ablassen der Schmelze hat,
wobei das Verfahren weiterhin einen Schritt des Passierens des verfestigten Körpers durch die Zone umfaßt, um denselben dadurch langsam abzukühlen.

## Revendications

1. Procédé pour fabriquer un fil supraconducteur composé d'un matériau supraconducteur en céramique d'une composition exprimée par une formule générale AaBbCc, dans lequel :
i) A représente un seul ensemble d'éléments sélectionnés dans un groupe, ledit groupe étant constitué de : (Bi, Sr et Ca ou Y et Ba ou La et Sr),
ii) B représente Cu (cuivre),
iii) C représente au moins un seul type d'élément sélectionné dans un groupe qui est constitué de l'oxygène, du soufre et du fluor, et
iv) a, b, c représentent les nombres montrant le rapport de composition de A, B et C, respectivement,
et ledit procédé comprenant les étapes consistant à :
une étape consistant à préparer un matériau brut pour ledit matériau supraconducteur en céramique,
une étape consistant à fondre ledit matériau brut dans un récipient ayant un trou,
une étape consistant à décharger linéairement ladite masse fondue à partir dudit trou soit par extrusion soit par tirage, et
une étape consistant à refroidir et solidifier ladite masse fondue déchargée linéairement afin d'obtenir un corps solidifié.

2. Procédé de fabrication d'un fil supraconducteur selon la revendication 1, dans lequel
ladite étape consistant à fondre ledit matériau brut afin d'obtenir une masse fondue comporte une étape consistant à ajouter au moins un seul type de composé de vitrification sélectionné dans un groupe constitué de B₂O₃, GeO₂ et P₂O₅ audit matériau dans ledit récipient de façon à obtenir une masse fondue dans un état vitreux visqueux.

3. Procédé de fabrication d'un fil supraconducteur selon la revendication 2, comprenant de plus une étape consistant à réchauffer ledit corps solidifié afin de cristalliser celui-ci.

4. Procédé de fabrication d'un fil supraconducteur selon la revendication 1, dans lequel
ledit matériau brut est d'une composition généralement exprimée dans une formule AaBbC^{x}c^{x}, où C^{x} représente au moins un seul type d'élément sélectionné dans un groupe constitué de l'oxygène, du soufre et du fluor et c^{x} représente un nombre montrant le rapport de composition de C^{x}, et
au moins une de ladite étape de fusion, de ladite étape de décharge, de ladite masse fondue et de ladite étape de refroidissement et de solidification a été effectuée dans une atmosphère contenant un composant C^{Y} de pression partielle qui est plus élevée que la pression partielle C^{Y} dans la pression atmosphérique, C^{Y} étant préparé par un gaz contenant au moins un seul type d'élément sélectionné dans un groupe qui est constitué de : l'oxygène, l'azote, le carbone, le fluor et le soufre et au moins contenant un élément laissé en éliminant ledit C^{x} dudit C si ledit C est constitué de deux ou plus types d'éléments.

5. Procédé de fabrication d'un fil supraconducteur selon la revendication 4, dans lequel
ledit C^{x} et ledit CY sont identiques audit C.

6. Procédé de fabrication d'un fil supraconducteur selon la revendication 4 ou 5, dans lequel
ladite étape de fusion comprend une étape consistant à ajouter ledit C^{Y} à ladite masse fondue dans une atmosphère contenant ledit composant C_{Y} d'une pression partielle qui est plus élevée que la pression partielle C^{Y} dans la pression atmosphérique.

7. Procédé de fabrication d'un fil supraconducteur selon au moins une des revendications 4 à 6, dans lequel
ladite étape de refroidissement et de solidification comprend une étape consistant à refroidir et solidifier ladite masse fondue dans une atmosphère contenant ledit composant C^{Y} de pression partielle qui est supérieure à la pression partielle C^{Y} dans la pression atmosphérique.

8. Procédé de fabrication d'un fil supraconducteur selon au moins une des revendications 4 à 7, comprenant de plus une étape consistant à réchauffer ledit corps solidifié dans une atmosphère contenant ledit composant C^{Y} de pression partielle qui est supérieure à la pression partielle C^{Y} dans la pression atmosphérique après ladite étape de refroidissement et de solidification.

9. Procédé de fabrication d'un fil supraconducteur selon la revendication 1, dans lequel
ledit matériau brut est d'une composition exprimée dans ladite formule générale AaBbCc, et
ladite étape de refroidissement et de solidification est effectuée dans un espace d'un niveau de température situé entre le point de solidification dudit matériau brut et celui inférieur de 100°C audit point de solidification.

10. Procédé de fabrication d'un fil supraconducteur selon la revendication 9, dans lequel
ladite étape de refroidissement et de solidification comprend une étape consistant à refroidir et solidifier ladite masse fondue dans un espace d'un niveau de température situé entre le point de solidification et celui inférieur de 50°C audit point de solidification.

11. Procédé de fabrication d'un fil supraconducteur selon la revendication 9 ou 10, dans lequel
une zone proche dudit espace pour effectuer ladite étape de refroidissement et de solidification est prévue à être à une température relativement élevée dans une partie plus proche dudit trou tout en ayant un gradient de température suivant une direction pour décharger linéairement ladite masse fondue,
ledit procédé comprenant de plus une étape consistant à passer ledit corps solidifié à travers ladite zone pour refroidir lentement de ce fait celui-ci.
